# EUROPEAN PATENT APPLICATION

(11) **EP 3 799 551 A1**
(43) Date of publication of application: **31.03.2021**
(21) Application number: 18919810.4
(22) Date of filing: 22.05.2018
(51) Int. Cl.: H05K 13/04

(54) **WORK HEAD MOUNTING STRUCTURE**

(71) Applicant: Fuji Corporation, Chiryu-shi, Aichi 472-8686 (JP)
(72) Inventor: ISHIKAWA Kenzo, Chiryu-shi, Aichi 472-8686 (JP); IMURA Jinya, Chiryu-shi, Aichi 472-8686 (JP); ITO Hidetoshi, Chiryu-shi, Aichi 472-8686 (JP); YAMAGIWA Masato, Chiryu-shi, Aichi 472-8686 (JP)
(74) Representative: Grünecker Patent- und Rechtsanwälte PartG mbB
(86) International application number: PCT/JP2018/019629
(87) International publication number: WO 2019/224904

(57) **Abstract**

A work head mounting structure includes: a positioning seat provided on a moving table driven by a head driving mechanism of a board work machine; a positioning section, being provided on a work head, which is configured to be fitted in the positioning seat to thereby position the work head in a set position with respect to the moving table; a board work machine side connector, being provided on the moving table, of which function is to provide an electrical connection; a head side connector, being provided on the work head, of which function is to provide an electrical connection; and an electrical connection section configured to slide and move the head side connector in an inserting direction relatively so as to fit the head side connector in the board work machine side connector with the work head being positioned in the set position.

## Description

### Technical Field

The present description relates to a mounting structure for a work head which is detachably attached to a board work machine.

### Background Art

The technique for mass production of circuit boards by applying board work to a board, on which wiring is printed, is wide-spreading. As a typical example of a board work machine for executing board work, there are raised a component mounter for executing component mounting work, a board inspection machine for executing board inspection work, and the like. In many component mounters, multiple mounting heads, which differ in type and number of component mounting tools that they hold, are prepared to be exchanged for use. Also, in some board inspection machines, multiple inspection heads, which differ in type and number of inspection cameras that they hold, may be prepared to be exchanged for use. Patent Literature 1 discloses an example of a technique for a mounting structure of a work head of this type (mounting head, inspection head).

The board work machine disclosed in Patent Literature 1 includes a detachable work head and performs pre-set work on a circuit board by operating the work head mounted then. According to the board work machine of Patent Literature 1, since the work head can be detached, it is understood that the convenience of the board work machine can be improved as by performing maintenance work easily or the like.

### Patent Literature

Patent Literature 1: JP-A-2004-221518

### Summary of the Invention

### Technical Problem

Although this is applied not only to Patent Literature 1 but also to other board work machines in general, in attaching a work head, in addition to mechanical positioning, fitting of connectors is also required for obtaining electrical connection such as for an a power supply line, a control line, or the like. Here, in a configuration in which a mechanical positioning and an electrical connection of connectors are performed simultaneously, in case an error occurs in positioning the connectors with respect to a positioning section, the connectors cannot be fitted together properly, whereby there is caused a possibility that the positioning operation is disturbed. In addition, in case the positioning operation is performed forcibly, there is caused a risk of the connectors being caused to fail. Further, a certain degree of pressing operation force is required to fit the connectors together, which disturbs the positioning operation. Furthermore, the attachment operation itself is complicated and troublesome, as well as difficult, because the mounting operation needs to be performed by paying attention to multiple portions.

On the other hand, there is a configuration in which a large degree of freedom (play in length) is provided for a power supply line or a control line, so that connectors are fitted together after they have been mechanically positioned. In this configuration, the connectors, the power supply line, and the control line sag, which may lead to a case in which a positioning operation is disturbed by them. That is, in positioning the connectors mechanically, attention has to be paid to the connectors, the power supply line, and the control line, which also makes the attachment operation complicated and troublesome, as well as difficult.

In addition, the operator exchanges work heads by following a predetermined exchanging procedure. In general, an exchange work is started after confirming that the power supply is cut off, and the power supply is resumed after confirming that a proper electrical connection state is secured after the exchange has been completed. However, work heads can be exchanged physically without following a prescribed exchanging procedure. As a result, there is a possibility that a power supply line or a control line is inserted or removed while the power supply line or the control line is in its live state.

A problem that is to be solved by the present description is how to provide a work head mounting structure for a board work machine which enables an attachment operation to be performed easily and reliably.

### Solution to Problem

According to the present description, there is disclosed a work head mounting structure comprising a positioning seat provided on a moving table driven by a head driving mechanism of a board work machine; a positioning section, being provided on a work head, which is configured to be fitted in the positioning seat to thereby position the work head in a set position with respect to the moving table; a board work machine side connector, being provided on the moving table, of which function is to provide an electrical connection; a head side connector, being provided on the work head, of which function is to provide an electrical connection; and an electrical connection section configured to slide and move the head side connector in an inserting direction relatively so as to fit the head side connector in the board work machine side connector with the work head being positioned in the set position.

### Advantageous Effect of the Invention

With the work head mounting structure disclosed in the present description, the positioning operation of the work head is performed first, and the electrical connection operation is performed subsequently. In addition, the electrical connection operation is made simple by sliding and moving the head side connector towards the board work machine side connector. That is, the attachment operation can be simplified by dividing it into the positioning operation and the electrical connection operation, which are performed separately, and the connectors are prevented from sagging, which does not disturb the positioning operation. Therefore, the operator can perform the attachment operation easily and reliably.

### Brief Description of Drawings

[Fig. 1] Fig. 1 is a perspective view showing a structure of a main part of a component mounter constituting an example of a board work machine to which a work head mounting structure of an embodiment is applied.
[Fig. 2] Fig. 2 is a block diagram showing a control configuration of the component mounter.
[Fig. 3] Fig. 3 is a side view of the work head mounting structure of the embodiment.
[Fig. 4] Fig. 4 is a side sectional view showing an arrangement of a board work machine side connector and a head side connector.
[Fig. 5] Fig. 5 is a perspective view showing structures of a protection cover and an electrical connection section.
[Fig. 6] Fig. 6 is a plan sectional view showing schematically a configuration of an error absorbing section of the electrical connection section.
[Fig. 7] Fig. 7 is a side view of the work head mounting structure showing a status at a point in time during a positioning operation.
[Fig. 8] Fig. 8 is a side view of the work head mounting structure showing a status resulting when the positioning operation ends.
[Fig. 9] Fig. 9 is a side view showing a status around the electrical connection section immediately before an electrical connection operation is started.
[Fig. 10] Fig. 10 is a side view showing a status resulting when which the electrical connection section slides and moves forwards generally halfway through a total sliding amount thereof.
[Fig. 11] Fig. 11 is a side view showing a status resulting when the electrical connection section slides and moves near a front end position.
[Fig. 12] Fig. 12 is a side sectional view showing a fit status of the head side connector and the board work machine side connector at the point in time when the status shown in Fig. 11 is attained.
[Fig. 13] Fig. 13 is a side view showing a status resulting when the electrical connection section slides and moves to the front end position to thereby end the electrical connection operation.

### Description of Embodiment

### 1. Structure of Board Work Machine (Component Mounter 1)

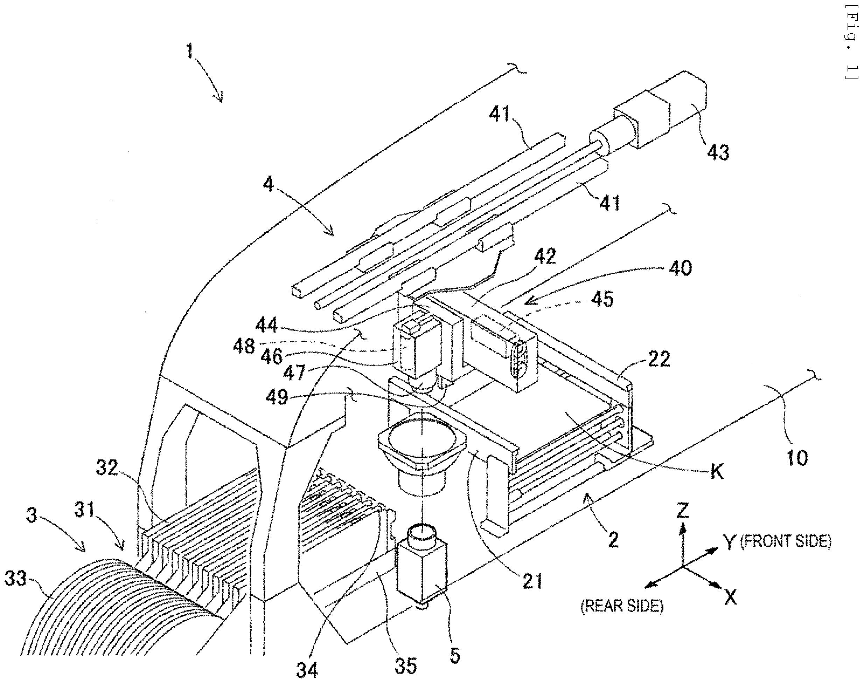

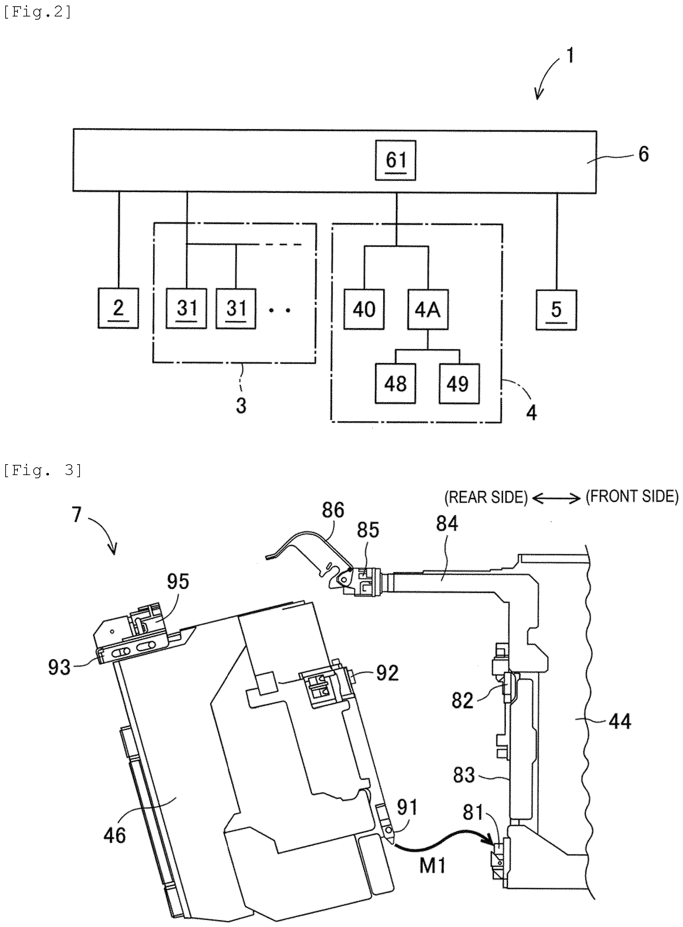

First of all, referring to Figs. 1 and 2, component mounter 1, which is an example of a board work machine, will be described. Fig. 1 is a perspective view showing a structure of a main part of component mounter 1, which constitutes an example of a board work machine to which work head mounting structure 7 of an embodiment is applied. In Fig. 1, a direction directed from a top left to a bottom right denotes an X-axis direction in which a board K is conveyed, a direction directed from a bottom left (a rear side) to a top right (a front side) denotes a Y-axis direction, and a vertical direction denotes a Z-axis direction. In addition, Fig. 2 is a block diagram showing a control configuration of component mounter 1. Component mounter 1 executes component mounting work repeatedly. Component mounter 1 is configured of board conveyance device 2, component supply device 3, component transfer device 4, part camera 5, control section 6 (refer to Fig. 2), device table 10, and the like.

Board conveyance device 2 is configured of first guide rail 21 and second guide rail 22, a pair of conveyor belts, a clamping device, and the like. First guide rail 21 and second guide rail 22 extend in the X-axis direction over device table 10 across a center thereof and are assembled to device table 10 parallel to each other. The pair of conveyor belts are provided side by side immediately below first guide rail 21 and second guide rail 22 in such a manner as to be disposed parallel to each other. The pair of conveyor belts rotate with board K placed on conveyor conveyance surfaces thereof and conveys board K in and out of a mounting execution position set at a central portion of device table 10. In addition, the clamping device is provided at the central portion of device table 10 below the conveyor belts. The clamping device pushes up board K with multiple push-up pins, clamps board K in a horizontal posture, and positions board K in the mounting execution position.

Component supply device 3 is detachably mounted at a rear side of component mounter 1. Component supply device 3 is configured of multiple feeder devices 31 which are placed side by side on device pallet 35. Feeder device 31 includes main body 32, supply reel 33 provided at a front side of main body 32, and component removal section 34 provided at a rear end of an upper portion of main body 32. Carrier tape, in which multiple components are sealed in at predetermined pitches, is wound around and held to supply reel 33. When this carrier tape is fed at the predetermined pitches, components are released from a sealed state and are subsequently fed into component removal section 34.

Component transfer device 4 is configured of pair of Y-axis rails 41, Y-axis moving table 42, Y-axis motor 43, X-axis moving table 44, X-axis motor 45, mounting head 46, in-head control section 4A, and the like. Pair of Y-axis rails 41 are disposed from a rear portion to a position lying above component supply device 3 provided at the front portion of device table 10. Y-axis moving table 42 is placed on pair of Y-axis rails 41. Y-axis moving table 42 is driven via a ball screw mechanism by Y-axis motor 43 and moves in the Y-axis direction.

X-axis moving table 44 is placed on Y-axis moving table 42. X-axis moving table 44 is driven via a ball screw mechanism by X-axis motor 45 and moves in the X-axis direction. Mounting head 46 is detachably attached to a rear side of X-axis moving table 44. Mounting head 46 corresponds to a work head of the board work machine. Y-axis rails 41, Y-axis moving table 42, Y-axis motor 43, and X-axis motor 45 configure head driving mechanism 40 for driving mounting head 46 together with X-axis moving table 44.

Mounting head 46 has rotary tool 47 at a lower side thereof. Although omitted in Fig. 1, multiple suction nozzles are disposed into a ring shape at a lower side of rotary tool 47. A suction nozzle set in an operation position as a result of a rotation of rotary tool 47 is driven by Z-axis motor 48 to be raised and lowered. The suction nozzle picks up a component from component removal section 34 by being supplied with a negative pressure and mounts the component on board K by being supplied with a positive pressure.

Mark camera 49 is provided at a lower side of mounting head 46 in such a manner as to be disposed side by side with rotary tool 47. Mark camera 49 images a position mark affixed to board K positioned in place and detects an accurate mounting execution position of board K. In-head control section 4A is provided within mounting head 46. In-head control unit 4A controls the rotation of rotary tool 47 and further controls Z-axis motor 48 and mark camera 49.

A driving section such as Z-axis motor 48 provided on mounting head 46 operates based on a drive power. In-had control section 4A, mark camera 49 and sensors, which are provided in and on mounting head 46, operate based on a control power supply. The drive power is supplied from X-axis moving table 44 by way of a driving power supply line. The control power supply is fed from X-axis moving table 44 by way of a control power supply line. Further, in-head control section 4A is connected with control section 6 for communication by way of X-axis moving table 44 by use of a control line.

Part camera 5 is provided on an upper face of device table 10 between board conveyance device 2 and component supply device 3 while being oriented upwards. Part camera 5 images a state of mounting head 46 which is on its way to board K with the multiple suction nozzles having picked up components from component removal section 34. As a result, part camera 5 can image the components held individually by the multiple suction nozzles all together at one time. Image data so captured is image processed to thereby check on suction states of the components, vertical and horizontal dimensions of the components, arrangement of connection electrodes, and the like.

Control section 6 holds job data for each type of board K and controls mounting work. The job data is data describing a detailed procedure and method of the mounting work. Control section 6 transmits various types of commands to board conveyance device 2, component supply device 3, head driving mechanism 40 and in-head control section 4A of component transfer device 4, and part camera 5. In addition, control section 6 receives information on operation statuses of these devices from them. Control section 6 may be configured of a single computer device or may be configured of multiple computer devices in such a manner as to distribute functions thereto. Control section 6 includes a function of power supply control section 61, which will be described in detail later.

### 2. Work Head Mounting Structure 7 of the Embodiment

Work head mounting structure 7 of the embodiment will be described next. Fig. 3 is a side view of work head mounting structure 7 of the embodiment. Fig. 3 shows a status resulting immediately before mounting head 46 is attached to X-axis moving table 44. Work head mounting structure 7 is configured of a member provided on X-axis moving table 44, a member provided on mounting head 46, and power supply control section 61.

First positioning seat 81, second positioning seat 82, electrical connection arm 84, board work machine side connector 85, and protection cover 86 are provided on X-axis moving table 44. First positioning seat 81 is disposed at a lower portion of a rear face of X-axis moving table 44. First positioning seat 81 is formed into a groove-like shape which opens upwards into a V-like shape. Second positioning seat 82 is disposed on the rear face of X-axis moving table 44 in a position lying slightly higher than a height of a middle portion of the rear face. Second positioning seat 82 is formed into a rectangular window-like shape. The rear face of X-axis moving table 44 also constitutes set position 83 where mounting head 46 is set.

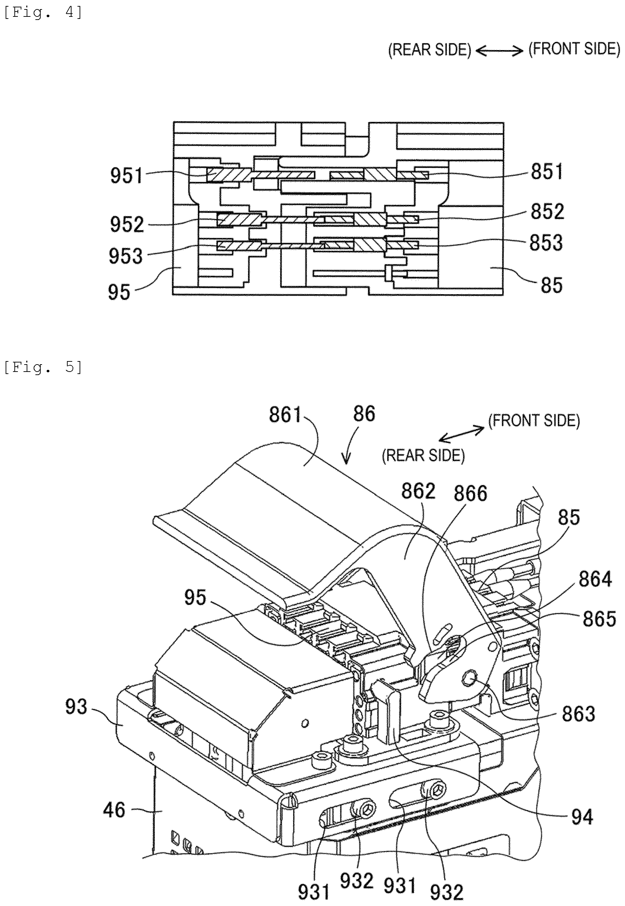

Electrical connection arm 84 is provided in such a manner as to extend horizontally from an upper portion of the rear face of X-axis moving table 44 to the rear. Board work machine side connector 85 is disposed at a rear portion of electrical connection arm 84. Board work machine side connector 85 takes on a role of providing an electrical connection. Fig. 4 is a side sectional view showing an arrangement of board work machine side connector 85 and head side connector 95 (which will be described later). In Fig. 4, the contacts are hatched with slant lines as a matter of convenience. Fig. 4 shows a state resulting at a point in time during an electrical connection operation.

As shown in Fig. 4, board work machine side connector 85 incorporates therein control contact 851, drive power contact 852, and control power supply contact 853 as viewed from top to bottom. Control contact 851 takes on a role of providing a connection of a control line. Drive power contact 852 takes on a role of providing a connection of a drive power line. Control power supply contact 853 takes on a role of connection of a control power supply line. Control contact 851 is disposed ahead of drive power contact 852 and control power supply contact 853.

Protection cover 86 is disposed in a position lying rearwards of and above board work machine side connector 85 in such a manner as to oscillate or swing. When operated to be closed, protection cover 86 protects board work machine side connector 85 and head side connector 95. Fig. 5 is a perspective view showing structures of protection cover 86 and electrical connection section 93 (which will be described later). Fig. 5 shows a state resulting immediately before an electrical connection operation is started with mounting head 46 positioned in set position 83 on X-axis moving table 44. Protection cover 86 is configured of cover section 861 and left and right side face portions 862. Cover section 861 is formed into a curved surface which is stretched between left and right side face portions 862 and extends from upper edges to rear edges of side face portions 862.

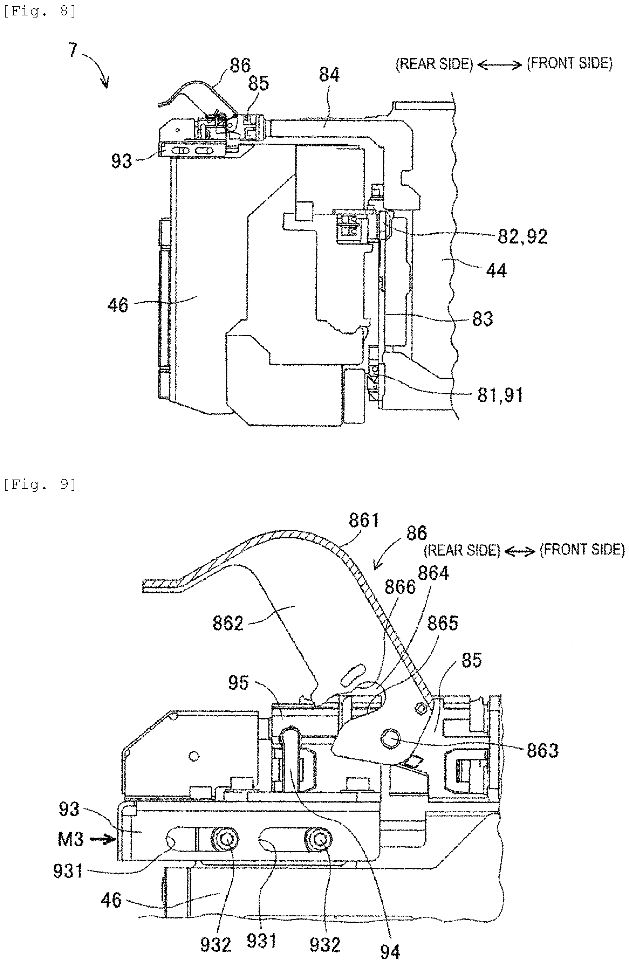

Rocking shaft section 863, which is pivotally supported on board work machine side connector 85 in such a manner as to rock, is provided closer to fronts of left and right sides 862. Operation groove 864, which opens downwards, is formed further rearwards than rocking shaft section 863 in side face portion 862. A connecting operation of electrical connection section 93 and a closing operation of protection cover 86 are interlocked with each other by a groove shape of operation groove 864. Front face 865 of operation groove 864 is formed into a convexly projecting shape as a result of an middle height portion bulging to the rear. On the other hand, rear face 866 of control groove 864 is formed into a convexly projecting shape as a result of a middle height portion bulging to the front, and a recessed shape is formed at each of a top and a bottom of the convexly projecting shape (refer to Fig. 9).

On the other hand, first positioning section 91, second positioning section 92, electrical connection section 93, and head side connector 95 are provided on mounting head 46. First positioning section 91 is disposed at a lower portion of a front face of mounting head 46. First positioning section 91 is formed into the shape of a protrusion protruding downwards into a wedge-like shape in such a manner as to fit in first positioning seat 81. Second positioning section 92 is disposed in a position lying slightly higher than a middle height portion of the front face of mounting head 46. Second positioning section 92 is formed into a rectangular projecting shape in such a manner as to fit in second positioning seat 82. Fit state of second positioning section 92 in second positioning seat 82 is maintained by use of a locking mechanism, not shown.

Mounting head 46 is positioned in set position 83 on X-axis moving table 44 as a result of first positioning section 91 fitting in first positioning seat 81 and second positioning section 92 fitting in second positioning seat 82. The details of structures for positioning mounting head 46 in a front-rear direction, a left-right direction, and an up-down direction and details of the locking mechanism are disclosed in Patent Literature 1.

Electrical connection section 93 is disposed in a position lying at a rear portion of an upper face of mounting head 46 in such a manner as to slide and move in the front-rear direction. Two elongated holes 931, extending in the front-rear direction, are opened in each of left and right side faces of electrical connecting section 93. Fastening bosses 932 of mounting head 46 are fitted loosely in corresponding elongated holes 931. Operation pin 94 is provided at each of the left and right of an upper face of electrical connection section 93 in such a manner as to be erected upwardly therefrom. A section of an upper portion of operation pin 94 is formed into a circular shape which expands diametrically outwards more than the other portions of operation pin 94. Operation pin 94 can fit loosely in operation groove 864 of protection cover 86. Operation pin 94 comes into contact with front face 865 and rear face 866 of operation groove 864 to thereby realize an interlocking operation between electrical connection section 93 and protection cover 86.

In the configuration described heretofore, the operator pushes on electrical connection section 93 to slide and move it to the front side. Since operation pin 94 pushes on front face 865 of operation groove 864 at a certain point in time while electrical connection section 93 is sliding to move to the front side, protection cover 86 is activated to perform a closing operation in association with the sliding movement of electrical connection section 93. Additionally, the operator may cause protection cover 86 to perform the closing operation after he or she has slid electrical connection section 93 to a certain point through a full slide thereof. In this case, since rear face 866 of operation groove 864 pushes operation pin 94 to move it to the front side, electrical connection section 93 slides and moves to the front side in association with the forward movement of operation pin 94. These operations and movements resulting therefrom will be described in detail later.

Electrical connection section 93 has head side connector 95 between two operation pins 94 on the upper face thereof. As a result, when electrical connection section 93 slides and moves to the front side, head side connector 95 also slides and moves to the front side. This causes head side connector 95 to approach board work machine side connector 85, and head side connector 95 eventually fits in board work machine side connector 85.

As shown in Fig. 4, head side connector 95 incorporates therein control contact 951, drive power contact 952, and control power supply contact 953 as viewed from a top to a bottom thereof. Control contact 951 comes into contact with control contact 851 of board work machine side connector 85 to thereby establish a connection of the control line. Drive power contact 952 comes into contact with drive power contact 852 to thereby establish a connection of the drive power line. Control power supply contact 953 comes into contact with control power supply contact 853 to thereby establish a connection of the control power supply line. Control contact 951 is disposed further rearwards than drive power contact 952 and control power supply contact 953.

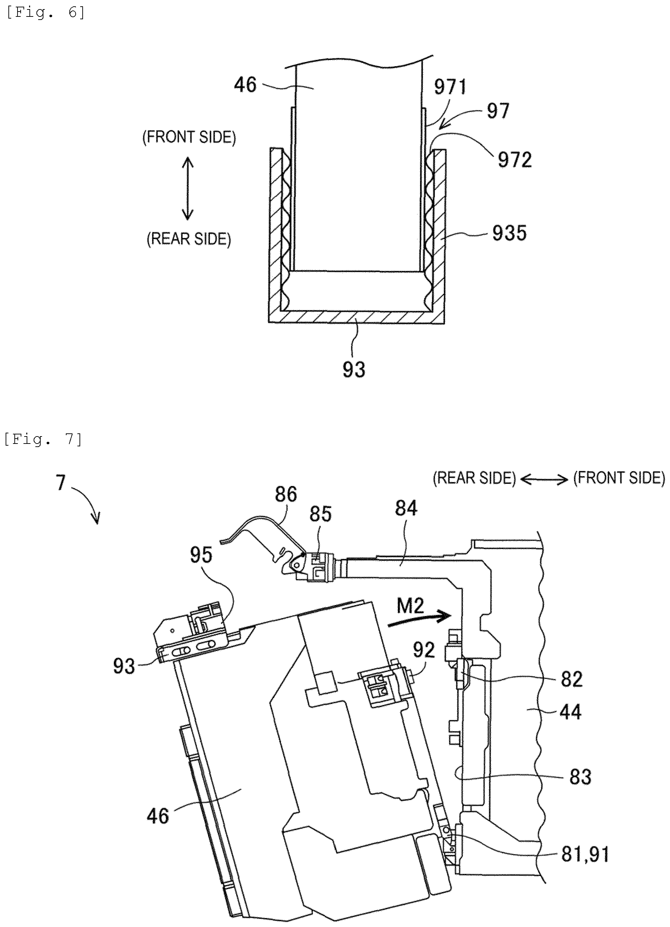

Fig. 6 is a plan sectional view showing schematically a configuration of error absorbing section 97 of electrical connection section 93. As shown in the figure, error absorbing section 97 is configured of sliding plate 971 and wave washer 972. Sliding plate 971 is affixed to each side face of mounting head 46. Sliding plate 971 maintains a sliding resistance to an appropriate value which occurs between another member and itself when the other member comes into contact with and moves along sliding plate 97. On the other hand, wave washer 972 is disposed inside left and right side plates 935 of electrical connection section 93. Wave washer 972 has a waveform shape and has such elasticity that allows a height of a waveform to change. When electrical connection section 93 slides and moves relative to mounting head 46, wave washer 972 slides on sliding plate 971.

With this configuration, the height of the waveform of first wave washer 972 can be increased, while the height of the waveform of second wave washer 972 can be reduced. In other words, a widthwise position of electrical connection section 93 can be adjusted relative to mounting head 46. Consequently, even though there exists an error in relative position due to an error in position between X-axis moving table 44 and mounting head 46, which is caused when head side connector 95 fits in board work machine side connector 85, error absorbing section 97 can absorb the error. That is, head side connector 95 on the upper face of electrical connection section 93 displaces in a width direction and is positioned square to board work machine side connector 85 so as to fit in board work machine side connector 85 well. Further, error absorbing section 97 doubles as a section acting to reduce and stabilize a required operation force when sliding and moving electrical connection section 93.

### 3. Procedure and Function of Attachment Operation of the Embodiment

Next, a procedure and function of work head mounting structure 7 of the embodiment will be described. An attachment operation of mounting head 46 is performed through a two-step operation of a positioning operation and an electrical connection operation. Firstly, the positioning operation will be described. Fig. 3, which has been described before, shows a status when the positioning operation is started. Fig. 7 is a side view of work head mounting structure 7 showing a status at a point in time while the positioning operation is being performed. Fig. 8 is a side view of work head mounting structure 7 showing a status resulting when the positioning operation ends.

As shown in Fig. 3, the operator holds mounting head 46 while inclining it in such a manner to put a lower portion forwards, so as to cause first positioning section 91 to fit in first positioning seat 81 (refer to arrow M1 in Fig. 3). Then, the status shown in Fig. 7 results. Next, the operator pushes a portion of mounting head 46 lying closer to a rear upper portion thereof to the front side. As a result, mounting head 46 oscillates or rocks in a clockwise direction in Fig. 7 around first positioning section 91 which has already fitted in the mating section (refer to arrow M2 in Fig. 7). Second positioning section 92 approaches second positioning seat 82 with an arc-shaped locus being traced, so as to fit in second positioning seat 82. Then, the status shown in Fig. 8 results when the positioning operation ends. As has been described heretofore, the positioning operation is very easy.

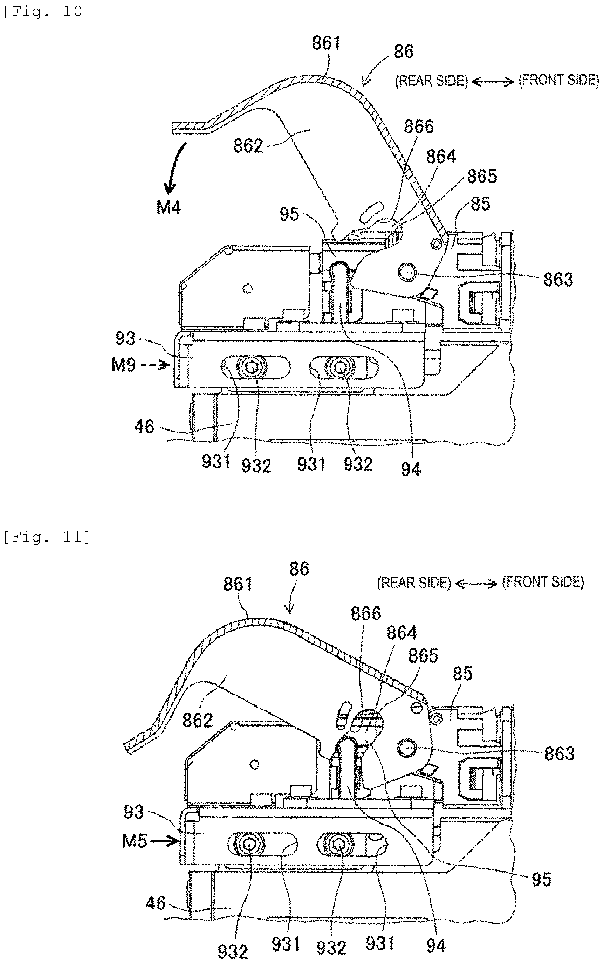

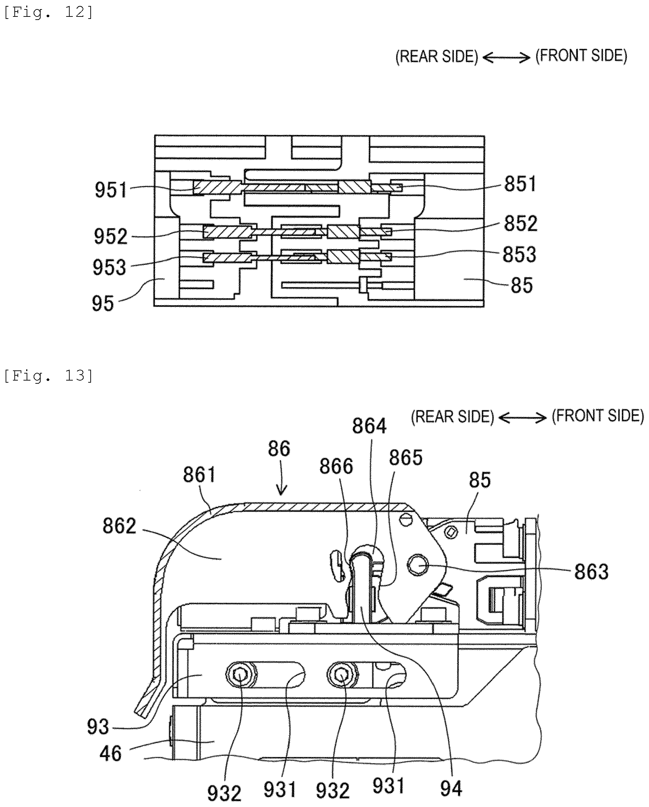

Next, the electrical connection operation will be described. Fig. 9 is a side view showing a status around electrical connection section 93 resulting immediately before the electrical connection operation is started. Fig. 9 is a partial enlarged view of Fig. 8. Fig. 10 is a side view showing a status resulting when electrical connection section 93 slides and moves forwards generally halfway through a total sliding amount thereof. Fig. 4, which has been described before, shows a fit status between head side connector 95 and board work machine side connector 85 at the point in time shown in Fig. 10. Fig. 11 is a side view showing a status resulting when electrical connection section 93 slides and moves near a front end position. Fig. 12 is a side sectional view showing a fit status of head side connector 95 and board work machine side connector 85 at the point in time when the status shown in Fig. 11 is attained. Fig. 13 is a side view showing a status resulting when electrical connection section 93 slides and moves to the front end position to thereby end the electrical connection operation.

In Fig. 9, electrical connection section 93 stays in a rear end position where front edges of elongated holes 931 are in contact with corresponding fastening bosses 932. At this point in time, head side connector 95 faces board work machine side connector 85 with a space defined therebetween. Protection cover 86 is open. The operator pushes electric connection section 93 to move it to the front side (refer to arrow M3 in Fig. 9). Then, electrical connection section 93 slides and moves to the front side to such an extent that operation pin 94 comes into contact with front face 865 of operation groove 864 of protection cover 86.

Electrical connection section 93 moves forwards generally halfway through the total sliding amount, resulting in the status shown in Fig. 10. At this point in time, as shown in Fig. 4, drive power contact 952 and drive power contact 852 have already come into contact with each other, and control power supply contact 953 and control power supply contact 853 have already come into contact with each other. However, there still remains a gap between control contact 951 and control contact 851, both of which have not yet come into contact with each other.

Here, power supply control section 61 controls the supply of power using the power supply line based on the connection state of the control line. To describe this in details, power supply control section 61 permits the supply of power after the control line is connected and permits the detachment of head side connector 95 from board work machine side connector 85 after the supply of power is stopped. Consequently, in the current point in time when control contact 951 is not in contact with control contact 851, power supply control section 61 prohibits the supply of power even though the drive power line and the control power supply line are connected.

In the status shown in Fig. 10, the operator pushes cover section 861 of protection cover 86 downwards to close protection cover 86 (refer to arrow M4 in Fig. 10). Protection cover 86 rocks counterclockwise, as seen in Fig. 10, around rocking shaft section 863 to close. As protection cover 86 so rocks, rear face 866 of operation groove 864 pushes operation pin 94 to move it to the front side. As a result, electrical connection section 93 slides and moves to the front side in association with the forward movement of operation pin 94 (refer to arrow 5 in Fig. 11), resulting in the status shown in Fig. 11.

At this point in time, as shown in Fig. 12, control contact 951 and control contact 851 are brought into contact with each other. Consequently, power supply control section 61 permits the supply of drive power and control power. As a result, the supply of drive power by the drive power line and the supply of control power by the control power supply line are started. Further, in-head control section 4A starts operating, whereby a communication by way of the control line is started. In this way, since the supply of power is started after confirming the connection of the control line, which is connected after the drive power line and the control power supply line have been connected, an inserting operation of head side connector 95 never occurs in a live wire state.

When protection cover 86 ends the closing operation, the electrical connection operation end status shown in Fig. 13 results. Electrical connection section 93 stays in a front end position where rear edges of elongated holes 931 are in contact with fastening bosses 932. Head side connector 95 and board work machine side connector 85 fit in and on each other well. Additionally, the mating contacts are brought into contact with each other with a sufficient contact area secured. To complement this, the mating contacts each hold a tolerance in contact position in a front-rear direction in consideration of a case in which a fitting error in the front-rear direction occurs between the mating connectors. By performing the operations and actions described above, electrical connection section 93 causes head side connector 95 to slide and move in an inserting direction relative to board work machine side connector 85 with mounting head 46 positioned in set position 83.

In the status shown in Fig. 10, the operator may push electrical connection section 93 further towards the front side (refer to dotted arrow M9 shown in Fig. 10). In this case, operation pin 94 pushes on front face 865 of operation groove 864 at a certain point in time during the forward sliding movement of electrical connection section 93. As a result, protection cover 86 operates to close in association with the pushing operation by operation pin 94. In this way, the electrical connection operation is ended by the associated operation even though protection cover 86 performs the closing operation or even though electrical connection section 93 performs the pushing operation. Consequently, the electrical connection operation becomes very easy, avoiding any risk of an occurrence of an error.

In addition, the removal operation of removing mounting head 46 from X-axis moving table 44 is executed through a two-step operation of an electrical connection releasing operation and a positioning releasing operation. In the electrical connection releasing operation, electrical connection section 93 and protection cover 86 are not associated with each other in operation. Due to this, the operator firstly opens protection cover 86, then slides and moves electrical connection section 93 to the rear, and finally removes head side connector 95 from the mating connector.

Further, power supply control section 61 permits head side connector 95 to be detached from board work machine side connector 85 after the supply of power is stopped. To realize this, for example, an electric lock mechanism is provided which is configured to lock electrical connection section 93 in the front end position, and this lock mechanism is driven from the control power supply line. Then, the lock mechanism is automatically released when the supply of control power is stopped, allowing electrical connection section 93 to slide and move to the rear side (the removal operation of head side connector 95). In this way, since the removal operation of head side connector 95 is permitted after the supply of power is stopped, the removal operation never occurs in the live wire state.

With work head mounting structure 7 of the embodiment, the positioning operation of mounting head 46 is performed first, and the electrical connection operation is performed subsequently. Additionally, the electrical connection operation is configured of the simple operation of sliding and moving head side connector 95 relative to board work machine side connector 85. That is, the attachment operation can be simplified by dividing it into the positioning operation and the electrical connection operation, which are performed separately, and the connectors are prevented from sagging, which does not disturb the positioning operation. Therefore, the operator can perform the attachment operation easily and reliably.

### 4. Applications and Modifications of the Embodiment

Even though X-axis moving table 44 has electrical connection section 93 with board work machine side connector 85 configured to slide and move, and mounting head 46 has protection cover 86, similar advantageous effects to those of the embodiment are provided. Although error absorbing section 97 described in the embodiment absorbs an error in the width direction, error absorbing section 97 can be configured to absorb an error in the up-down direction. Further, work head mounting structure 7 can also be applied to other board work machines than component mounter 1, for example, a board inspection machine. The present embodiment can be applied and modified in other various forms.

### Reference Signs List

1: component mounter, 2: board conveyance device, 3: component supply device, 4: component transfer device, 40: head driving mechanism, 44: X-axis moving table, 46: mounting head, 5: part camera, 6: control section, 61: power supply control section, 7: work head mounting structure, 81: first positioning seat, 82: second positioning seat, 83: set position, 85: board work machine side connector, 86: protection cover, 91: first positioning section, 92: second positioning section, 93: electrical connection section, 95: head side connector, 97: error absorbing section

## Claims

1. A work head mounting structure comprising:
a positioning seat provided on a moving table driven by a head driving mechanism of a board work machine;
a positioning section, being provided on a work head, which is configured to be fitted in the positioning seat to thereby position the work head in a set position with respect to the moving table;
a board work machine side connector, being provided on the moving table, of which function is to provide an electrical connection;
a head side connector, being provided on the work head, of which function is to provide an electrical connection; and
an electrical connection section configured to slide and move the head side connector in an inserting direction relatively so as to fit the head side connector in the board work machine side connector with the work head being positioned in the set position.

2. The work head mounting structure according to claim 1,
wherein the electrical connection section has an error absorbing section configured to absorb an error in a relative position occurring when the head side connector fits in the board work machine side connector.

3. The work head mounting structure according to claim 1 or 2,
wherein the positioning seat comprises a first positioning seat and a second positioning seat, and
wherein the positioning section comprises a first positioning section configured to fit in the first positioning seat, and a second positioning section configured to approach the second positioning seat with an arc-shaped locus being traced so as to fit in the second positioning section, with the first positioning section fitting in the first positioning seat.

4. The work head mounting structure according to any one of claims 1 to 3,
wherein a connection operation in which the electrical connection section slides and moves the head side connector relatively in the inserting direction is associated with a closing operation in which a protection cover for protecting the board work machine side connector and the head side connector closes.

5. The work head mounting structure according to any one of claims 1 to 4,
wherein the board work machine side connector and the head side connector have power supply contacts configured to be brought into contact with each other to thereby connect a power supply line, and control contacts configured to be brought into contact with each other to thereby connect a control line after the power supply contacts have been done, when the work head side connector fits in the board work machine side connector, and
wherein the work head mounting structure comprises further a power supply control section configured to control a supply of power using the power supply line based on a connection state of the control line.

6. The work head mounting structure according to claim 5,
wherein the power supply control section
permits the supply of power after the control line is connected when the head side connector fits in the board work machine side connector, and
permits the head side connector to be detached from the board work machine side connector after the supply of power is stopped.
